# EUROPÄISCHE PATENTSCHRIFT

(11) **EP 0 824 851 B1**
(45) Veröffentlichungstag und Bekanntmachung des Hinweises auf die Patenterteilung: **25.10.2000**
(21) Anmeldenummer: 96910904.0
(22) Anmeldetag: 20.04.1996
(51) Int. Cl.: H05K 5/06, F16J 15/14

(54) **FLEXIBLE DICHTUNG UND EIN VERFAHREN ZU DEREN HERSTELLUNG**
FLEXIBLE SEAL AND PROCESS FOR ITS PRODUCTION
GARNITURE D'ETANCHEITE FLEXIBLE ET SON PROCEDE DE PRODUCTION

(30) Priorität: 06.05.1995 DE 19516708
(43) Veröffentlichungstag der Anmeldung: 25.02.1998
(73) Patentinhaber: ROBERT BOSCH GMBH, 70442 Stuttgart (DE)
(72) Erfinder: GAEGE, Götz, D-71334 Waiblingen (DE); HUSSMANN, Dieter, D-71711 Steinheim (DE); WEBER, Didier, D-71665 Vaihingen (DE)
(86) Internationale Anmeldenummer: DE9600696
(87) Internationale Veröffentlichungsnummer: WO9635320

(56) Entgegenhaltungen:
- EP-A- 0 558 033
- WO-A-91/07865
- DE-U- 9 404 291
- US-A- 4 950 521
- PATENT ABSTRACTS OF JAPAN vol. 5, no. 114 (C-064), 23.Juli 1981 & JP,A,56 053172 (YOKOHAMA RUBBER CO. LTD 12 05 81)
- PATENT ABSTRACTS OF JAPAN vol. 10, no. 105 (M-471) [2162] , 19.April 1986 & JP,A,60 237267 (THREE BOND K.K.), 26.November 1985,

## Beschreibung

Die Erfindung betrifft eine flexible Dichtung und ein Herstellungsverfahren nach dem Oberbegriff des Hauptanspruchs.

Es ist bereits aus der DE-OS 39 37 190 eine Dichtung für ein elektrisches Gerät mit zwei Gehäuseteilen bekannt. Das bekannte elektrische Gerät enthält eine Steuerelektronik für einen automatischen Blockierschutz (ABS/ABSR) eines Bremssystems eines Kraftfahrzeugs und ist im Bereich des Motorraumes angebracht. Das Gehäuse soll nach der Montage des elektrischen Geräts über einen längeren Zeitraum dicht sein und die empfindlichen elektrischen Schaltungselemente in seinem Inneren insbesondere vor Feuchtigkeit und aggressiven Fremdstoffen schützen. Bei einem Kraftfahrzeug können beispielsweise Spritzwasser, Salznebel, Staub oder sonstige am Einbauort der Steuerelektronik vorkommende chemische Agenzien zu schädlichen Auswirkungen führen. Die bekannten Dichtungen sind in der Regel Form- oder Stanzdichtungen aus Elastomeren, die auf die Gehäuseteile aufgebracht werden.

In der US-A- 4 950 521 wird eine Dichtung aus einem anderen Werkstoff beschrieben. Hier wird eine Dichtmasse auf Basis von raum- oder niedertemperaturvernetztem Siliconkautschuk auf eine vorgegebene Dichtfläche zwischen zwei Gehäuseteilen aufgebracht und zwischen diesen eingespannt.

Im Patent Abstract of Japan Vo. 5, No. 114 (C-064), 23. Juli 1981 (JP-A-56 053 172) ist eine Dichtung beschrieben, deren Werkstoff zwar eine Butylgruppe enthält, es liegt aber hier eine Vulkanisation vor, zu der ein Beschleuniger zugesetzt wird.

### Vorteile der Erfindung

Die erfindungsgemäße flexible Dichtung der oben angegebenen Art ist mit den kennzeichnenden Merkmalen des Anspruchs 1 insbesondere dadurch vorteilhaft, daß beim Zusammenfügen der Gehäuseteile die Dichtungsmasse in die Rauhigkeit der Fügefläche eindringen kann und somit zu einer elastischen und sehr dichten Verbindung der Gehäuseteile führt. Gegenüber den bekannten Dichtungen aus Elastomeren fallen bei der erfindungsgemäßen Dichtung keinerlei Werkzeugkosten für die Formteile bzw. kein Stanzabfall bei aus Platten gestanzten Dichtungen an.

Im Unterschied zu anderen plastisch auftragbaren Materialien, wie zum Beispiel Silikon oder Acrylaten, ist bei der erfindungsgemäßen Dichtungsmasse keine Aushärtung notwendig, da der Butylkautschuk nach dem Auftragen der Dichtung sofort erkaltet. Auch die bei den bekannten Verfahren entstehenden chemischen Abspaltprodukte, wie Essigsäure, Methanol, Amine oder monomere Acrylate emittieren bei der erfindungsgemäßen Dichtungsmasse nicht, so daß sich insgesamt ein umweltfreundlicher Herstellungsprozeß realisieren läßt. Auch die Entsorgung ist umweltfreundlich durchführbar, da der Butylkautschuk als Kohlenwasserstoff beim Recycling der Gehäuseteile in der Metallschmelze zu Kohlendioxid und Wasser verbrennt.

Gemäß Unteranspruch 2 wird durch die Zumengung von mineralischen Füllstoffen in vorteilhafter Weise eine Verbesserung der plastischen Eigenschaften und Verarbeitbarkeit der Dichtmasse herbeigeführt.

Im Anspruch 3 und den folgenden Unteransprüchen ist ein vorteilhaftes Herstellungsverfahren für die erfindungsgemäße flexible Dichtung angegeben, das eine einfache Aufbringung der erhitzten Dichtmasse aus Butylkautschuk auf die Dichtflächen gewährleistet und nach der in wenigen Sekunden erfolgten Erkaltung der Dichtmasse eine plastische und dichte Verbindung zweier Gehäuseteile ermöglicht.

### Zeichnung

Ein Ausführungsbeispiel der erfindungsgemäßen flexiblen Dichtung wird anhand der Zeichnung erläutert. Es zeigen:
Figur 1 eine Draufsicht auf ein Gehäuseteil eines elektrischen Geräts mit einer raupenförmigen Dichtmasse aus Butylkautschuk auf einer Dichtfläche und
Figur 2 einen Schnitt durch die aufgetragene Dichtmasse.

### Beschreibung des Ausführungsbeispiels

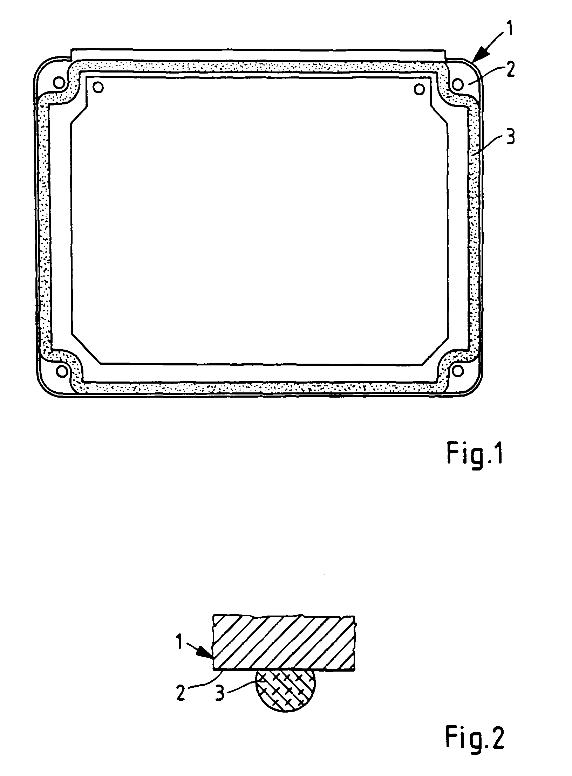

In der Figur 1 ist ein Gehäuseteil 1 als Bestandteil eines Gehäuses für ein elektrisches Gerät gezeigt, wobei dieses Gehäuseteil 1 auch ein Bestandteil einer mechanischen Anordnung sein kann, die durch das elektrische Gerät gesteuert wird. Beispielsweise kann das Gehäuse eine Motorsteuerelektronik beinhalten, die am Motorblock eines Kraftfahrzeuges montiert wird. An einer Dichtfläche 2, die mit einem zweiten, hier nicht dargestellten Gehäuseteil, verbindbar ist, befindet sich eine Dichtmasse 3 aus Butylkautschuk.

Die Dichtmasse 3 aus Butylkautschuk mit einem Zusatz von mineralischen Füllstoffen ist hierbei durch eine beheizbare Auftragsdüse von einer Kolbenpumpe und einer nachgeschalteten Zahnradpumpe auf die Dichtfläche 2 aufgetragen worden. Die Kolbenpumpe, die Zahnradpumpe und die Auftragsdüse sind Bestandteil einer herkömmlichen bahngesteuerten Fertigungsanlage, die hier nicht dargestellt ist. Mit der freiprogrammierbaren Bahnsteuerung lassen sich auch komplizierte, beispielsweise verwinkelte Dichtflächen nicht nur zweidimensional, sondern auch in der dritten Dimension versorgen. Die Dichtmasse erkaltet hierbei in wenigen Sekunden nach dem Auftragen, so daß die Gehäuseteile unmittelbar danach aneinandergefügt werden können, wobei die Dichtmasse 3 auch dann noch ein plastisches Verhalten aufweist. In Figur 2 ist ein Schnitt durch die Dichtmasse 3 kurz nach dem Auftragen auf die Dichtfläche 2 dargestellt.

## Patentansprüche

1. Flexible Dichtung zwischen zwei Gehäuseteilen, vorzugsweise für ein elektrisches Gerät, mit
- einer, auf mindestens einer vorgegebenen Dichtfläche (2) zwischen den Gehäuseteilen (1) angeordneten Dichtmasse (3), die beim Zusammenfügen der Gehäuseteile (1) zwischen diesen eingespannt ist, dadurch gekennzeichnet, daß
- die Dichtmasse (3) aus Butylkautschuk besteht, der beim Auftragen auf die Dichtfläche (2) erwärmt wurde.

2. Flexible Dichtung nach Anspruch 1, **dadurch gekennzeichnet**, daß
- der Dichtmasse (3) aus Butylkautschuk mineralische Füllstoffe zugesetzt sind.

3. Verfahren zur Herstellung einer flexiblen Dichtung zwischen zwei Gehäuseteilen nach Anspruch 1 oder 2, **dadurch gekennzeichnet**, daß
- die Dichtmasse (3) mittels einer Kolbenpumpe und einer nachgeschalteten Zahnradpumpe zu einer beheizbaren Auftragsdüse transportiert wird, daß
- die Auftragsdüse mittels einer freiprogrammierbaren Bahnsteuerung, entlang der vorgegebenen Dichtfläche (2) geführt wird, wobei die Dichtmasse in der Auftragsdüse erwärmt wird, und daß
- nach dem Erkalten der Dichtmasse (3) die Gehäuseteile (1) aneinandergefügt werden, wobei sich die Dichtmasse (3) plastisch verformt.

4. Verfahren nach Anspruch 3, **dadurch gekennzeichnet**, daß
- die Dichtmasse (3) in der Auftragsdüse auf eine Temperatur von 130°C bis 170°C erwärmt wird.

5. Verfahren nach einem der Ansprüche 3 oder 4, **dadurch gekennzeichnet**, daß
- die Dichtmasse (3) eine als abgeflachte Rundschnur gebildete Raupe ist.

6. Flexible Dichtung oder Verfahren nach einem der vorhergehenden Ansprüche, dadurch gekennzeichnet, daß die Gehäuseteile Teile eines Geräts für eine elektronische Steuerung in einem Kraftfahrzeug sind.

## Claims

1. Flexible gasket between two housing parts, preferably for an electrical instrument, with a sealing compound (3) which is arranged on at least one predetermined sealing surface (2) between the housing parts (1) and which is clamped between the housing parts (1) when these are joined together, characterized in that the sealing compound (3) consists of butyl rubber which was heated when applied to the sealing surface (2).

2. Flexible gasket according to Claim 1, characterized in that the mineral fillers are added to the sealing compound (3) consisting of butyl rubber.

3. Method for producing a flexible gasket between two housing parts according to Claim 1 or 2, characterized in that the sealing compound (3) is transported to a heatable applicator nozzle by means of a piston pump and a following gear pump, in that the applicator nozzle is guided along the predetermined sealing surface (2) by means of a freely programmable path control, the sealing compound being heated in the applicator nozzle, and in that, after the cooling of the sealing compound (3), the housing parts (1) are joined to one another, the sealing compound (3) experiencing plastic deformation.

4. Method according to Claim 3, characterized in that the sealing compound (3) is heated in the applicator nozzle to a temperature of 130°C to 170°C.

5. Method according to one of Claims 3 or 4, characterized in that the sealing compound (3) is a bead formed as a flattened round cord.

6. Flexible gasket or method according to one of the preceding claims, characterized in that the housing parts are parts of an instrument for an electronic control in a motor vehicle.

## Revendications

1. Garniture d'étanchéité souple entre deux parties d'un boîtier, plus particulièrement pour un appareil électrique, avec une matière d'étanchéité (3) appliquée sur au moins une surface à étancher (2) entre les parties (1) d'un boîtier, et serrée entre celles-ci lors de leur assemblage,
caractérisée en ce que,
la matière d'étanchéité (3) est en caoutchouc butyle, réchauffée lors de son application sur la surface à étancher (2).

2. Garniture d'étanchéité souple selon la revendication 1,
caractérisée en ce qu'
à la matière d'étanchéité (3) en caoutchouc butyle, sont ajoutées des charges minérales.

3. Procédé de fabrication d'une garniture souple, selon la revendication 1 ou 2, destinée à réaliser l'étanchéité entre deux parties d'un boîtier,
caractérisé en ce que,
- la matière d'étanchéité (3) est transportée vers une buse d'application réchauffée, au moyen d'une pompe à pistons et d'une pompe à engrenages branchée en aval,
- l'application de la buse est dirigée le long de la surface à étancher (2), au moyen d'une commande librement programmable, la matière d'étanchéité (3) ayant été réchauffée dans la buse d'application, et
- à la suite du refroidissement de la matière d'étanchéité (3) les parties du boîtier (1) sont appliquées l'une contre l'autre, provoquant une déformation plastique de cette matière (3)

4. Procédé selon la revendication 3,
caractérisé en ce que
la matière d'étanchéité (3) est chauffée dans la buse d'application, à une température comprise entre 130°C et 170°C.

5. Procédé selon l'une des revendications 3 ou 4,
caractérisé en ce que
la matière d'étanchéité (3) est constituée par un boudin en forme de cordon rond aplati.

6. Garniture d'étanchéité ou procédé selon l'une des revendications précédentes,
caractérisé en ce que
les parties du boîtier constituent des parties d'un appareil de commande électronique monté dans un véhicule.
